# EUROPEAN PATENT APPLICATION

(11) **EP 0 866 551 A2**
(43) Date of publication of application: **23.09.1998**
(21) Application number: 98104212.0
(22) Date of filing: 10.03.1998
(51) Int. Cl.: H03H 9/02

(54) **Surface acoustic wave element**

(30) Priority: 21.03.1997 JP 68370/97; 24.03.1997 JP 69620/97; 02.07.1997 JP 177144/97
(71) Applicant: MITSUBISHI MATERIALS CORPORATION, Chiyoda-ku, Tokyo (JP)
(72) Inventor: Jian, Chunyun, Mitsubishi Materials Corporation, Yokozemachi, Chichibu-gun, Saitama-ken (JP); Inui, Sinichro, Mitsubishi Materials Corporation, Yokozemachi, Chichibu-gun, Saitama-ken (JP)
(74) Representative: Türk, Gille, Hrabal, Leifert

(57) **Abstract**

The present invention relates to a surface acoustic wave element used in an element or the like of a filter for selecting frequency used in a communication device or the like, a resonator used in a highly stabilized oscillator or the like, with an object of providing a surface acoustic wave element having a small temperature coefficient of delay and a comparatively large electromechanical coupling coefficient and having a chemically stable substrate material, in which a langasite substrate is used and when a cut-out angle from langasite single crystal and a direction of propagating a surface acoustic wave are (180°+α, 40°+β, 20°+γ) in Eulerian angles expression, α=-2° through +6°, β=-4° through +9°, γ=-1° through +9°, or α=-6° through 6°, β=-5° through 5°, γ=-5° through 5° in the case of (9°+α, 150°+β, 37°+γ), or α=-5° through 5°, β=-5° through 5°, γ=-5° through 5° in the case of (0°+α, 140°+β, 24°+γ) or orientations equivalent thereto.

## Description

### BACKGROUND OF THE INVENTION

### Field of the Invention

The present invention relates to a surface acoustic wave element used in an element or the like of a filter for selecting frequency used in a communication device, a resonator used in an oscillator with high stability and so on.

### Description of the Related Art

Conventionally, as a substrate for a surface acoustic wave element, there has generally been used a substrate produced by cutting and polishing a piezoelectric single crystal of lithium niobate, lithium tantalate, lithium tetraborate (for example, refer to Japanese Unexamined Patent Publication No. JP-A-60-41315), crystallized quartz or the like by a pertinent cut face.

As functions which are important in a piezoelectric substrate used in a surface acoustic wave element, a Temperature Coefficient of a Delay (TCD) and an Electromechanical Coupling Coefficient (K²) are pointed out. The nearer the TCD to null and the larger the K², the more preferable are these coefficients for a substrate for a surface acoustic wave element. Conventionally, as a substrate for a surface acoustic wave element, there has generally been used a substrate produced by cutting and polishing a piezoelectric single crystal of lithium niobate (LiNbO₃), lithium tantalate (LiTaO₃), lithium tetraborate (Li₂B₄O₇), crystallized quartz or the like by a pertinent cut face. In the case of LiNbO₃ (for example, 128° Y cut - X propagation), although K² is as large as 5.5 %, TCD is as large as 74 ppm/°C and accordingly, drift of frequency caused by temperature change is caused and the substrate cannot be used in a filter requiring a narrow band characteristic, an oscillator requiring a highly stabilized accuracy and the like. Further, in the case of Li₂B₄O₇ (for example, 45° X cut - Z propagation), although K² is 1 % and TCD is 0 ppm/°C, the substrate is dissolved in water and it bears a deliquescence property and accordingly, processing thereof is difficult and reliability is deteriorated. Further, although ST cut crystallized quartz is provided with null TCD, K² is as small as 0.1 % and therefore, a filter having a wide band cannot be obtained.

From a request for a surface acoustic wave element having a higher function and figher-frequency performance, a substrate material where TCD is near to null and the larger K² is obtained and which is chemically stable has been required.

### SUMMARY OF THE INVENTION

In view of the above-described situation, it is an object of the present invention to provide a surface acoustic wave element having small TCD and comparatively large K² and having a chemically stable substrate material.

According to a first aspect of the present invention to achieve the above-described object, there is provided a surface acoustic wave element in which a metal film for exciting, receiving or reflecting a surface acoustic wave is formed on a substrate of langasite (La₃Ga₅SiO₁₄) single crystal, wherein when a cut-out angle from the single crystal of the langasite substrate and a direction of propagating the surface acoustic wave are designated by (180°+α, 40°+β, 20°+γ) in Eulerian angles (Euler angles) expression, α=-2° through +6°, β=-4° through +9°, γ=-1° through +9° or an orientation equivalent thereto.

Further, according to a second aspect of the present invention to achieve the above-described object, there is provided a surface acoustic wave element in which a metal thin film for exciting, receiving or reflecting a surface acoustic wave is formed on a substrate of langasite (La₃Ga₅SiO₁₄) single crystal, wherein when a cut-out angle from the single crystal of the langasite substrate and a direction of propagating the surface acoustic wave are designated by (9°+α, 150°+β, 37°+γ) in Eulerian angles expression, α=-6° through 6°, β=-5° through 5°, γ=-5° through 5° or an orientation equivalent thereto.

Here, according to the surface acoustic wave element of the second aspect of the present invention, it is particularly preferable that the cut-out angle from the single crystal of the langasite substrate and the direction of propagating the surface acoustic wave are (13.4°, 150.5°, 37.2°) in Eulerian angles expression or an orientation equivalent thereto.

Further, according to a third aspect of the present invention to achieve the above-described object, there is provided a surface acoustic wave element in which a metal thin film for exciting, receiving or reflecting a surface acoustic wave is formed on a substrate of langasite (La₃Ga₅SiO₁₄) single crystal, wherein when a cut-out angle from the single crystal of the langasite substrate and a direction of propagating the surface acoustic wave are designated by (0°+α, 140°+β, 24°+γ) in Eulerian angles expression, α=-5° through 5°, β=-5° through 5°, γ=-5° through 5° or an orientation equivalent thereto.

According to the surface acoustic wave element of the third aspect of the present invention, it is particularly preferable that the cut-out angle from the single crystal of the langasite substrate and the direction of propagating the surface acoustic wave are (0°, 140°, 24°) in Eulerian angles expression or an orientation equivalent thereto.

The inventors have achieved the present invention by discovering that a surface acoustic wave element in which a metal film is formed in a propagation orientation at a specific cut face of langasite (La₃Ga₅SiO₁₄) which is a single crystal having a piezoelectric performance, is provided with a small temperature coefficient of delay and a comparatively large electromechanical coupling coefficient and is chemically stable.

According to the present invention, there is provided a surface acoustic wave element having a small temperature coefficient of delay and a comparatively large electromechanical coupling coefficient and having a chemically stable substrate material.

### BRIEF DESCRIPTION OF THE DRAWINGS

Fig. 1 is a schematic view of a transmission type SAW (Surface Acoustic Wave) filter;
Fig. 2 shows a graph indicating changes in K² and TCD of a cut face of (175°-185°, 40°, 20°);
Fig. 3 shows a graph indicating changes in K² and TCD of a cut face of (180°, 35°-45°, 20°);
Fig. 4 shows a graph indicating changes in K² and TCD of a cut face of (180°, 40°, 15°-25°);
Fig. 5 shows a graph indicating temperature dependency of a central frequency;
Fig. 6 shows a graph indicating changes in K² and TCD of a cut face of (3°-15°, 150.5°, 37.2°);
Fig. 7 shows a graph indicating changes in K² and TCD of a cut face of (10°, 146°-156°, 37.2°);
Fig. 8 shows a graph indicating changes in K² and TCD of a cut face of (10°, 150.5°, 32°-42°);
Fig. 9 shows a graph indicating temperature dependency of a central frequency;
Fig. 10 shows a graph indicating changes in K² and TCD of a cut face of (-5°-5°, 140°, 24°);
Fig. 11 shows a graph indicating changes in K² and TCD of a cut face of (0°, 135°-145°, 24°);
Fig. 12 shows a graph indicating changes in K² and TCD of a cut face of (0°, 140°, 19°-29°); and
Fig. 13 shows a graph indicating temperature dependency of a central frequency.

### DETAILED DESCRIPTION OF THE PREFERRED EMBODIMENTS

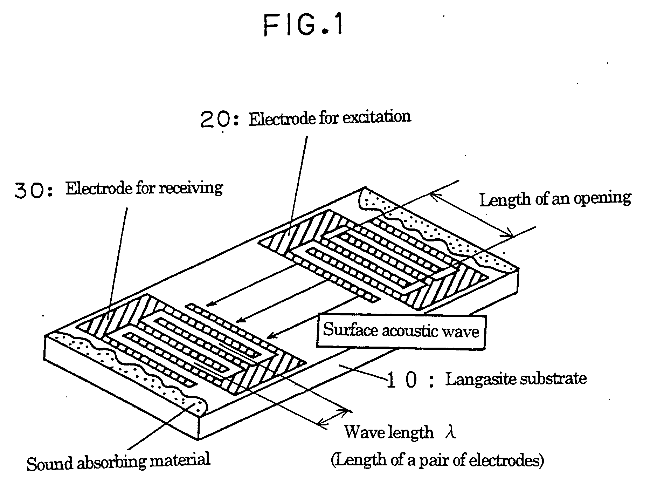

Fig. 1 is a schematic view of a transmission type SAW filter.

When a pair of comb-like electrodes are formed on a langasite single crystal substrate 10 and a high frequency voltage is applied on one of these (electrode for excitation 20), a surface acoustic wave is excited and reaches a receiving electrode 30. A band-pass filter characteristic is produced in the frequency characteristic between an input and an output of these and a temperature characteristic of the filter is determined by a property of the piezoelectric crystal.

As constants necessary for calculating the characteristic of the surface acoustic wave on the langasite single crystal, there are shown a density, an elastic constant, a piezoelectric constant, a dielectric constant and a linear expansion coefficient at 20 °C in Table 1 shown below.

Further, Table 2 shows primary and secondary temperature coefficients thereof.

**Table 1**

| Various constants of langasite used in calculation | | |
|---|---|---|
| Measured temperature °C | | 20 |
| Density ρ (Kg/m³) | | 5764 |
| Elastic constant, C^{E} (10¹⁰N/m²) | C^{E}₁₁ | 18.93 |
| | C^{E}₁₂ | 10.50 |
| | C^{E}₁₃ | 9.528 |
| | C^{E}₁₄ | 1.493 |
| | C^{E}₃₃ | 26.24 |
| | C^{E}₄₄ | 5.384 |
| | C^{E}₆₆ | 4.216 |
| Piezoelectric constant, e (C/m²) | e₁₁ | -0.431 |
| | e₁₄ | 0.108 |
| Dielectric constant, ε^{T}/ε⁰ | ε^{T}₁₁/ε⁰ | 18.97 |
| | ε^{T}₃₃/ε⁰ | 52.00 |
| Linear expansion coefficient, λ (10⁻⁶/K) | λ₁₁ | 5.07 |
| | λ₃₃ | 3.60 |

**Table 2**

| Temperature coefficients of respective constants of langasite used in calculation | | | |
|---|---|---|---|
| Measured temperature°C | | 20 | |

| | | Primary coefficient (10⁻⁵/K) | Secondary coefficient (10⁻⁹/K) |
|---|---|---|---|
| Elastic constant, C^{E} (10¹⁰N/m²) | C^{E}₁₁ | -53 | -4.2 |
| | C^{E}₁₂ | -92 | +25 |
| | C^{E}₁₃ | -88 | -131 |
| | C^{E}₁₄ | -205 | +870 |
| | C^{E}₃₃ | -104 | -109 |
| | C^{E}₄₄ | -62 | -111 |
| | C^{E}₆₆ | -4.7 | -40.7 |
| Piezoelectric constant, e (C/m²) | e₁₁ | 456 | 1032 |
| | e₁₄ | -628 | 1480 |
| Dielectric constant, ε^{T}/ε⁰ | ε^{T}₁₁/ε⁰ | 137 | 82 |
| | ε^{T}₃₃/ε⁰ | -795 | 1076 |

An explanation will firstly be given of a first embodiment of the present invention as follows.

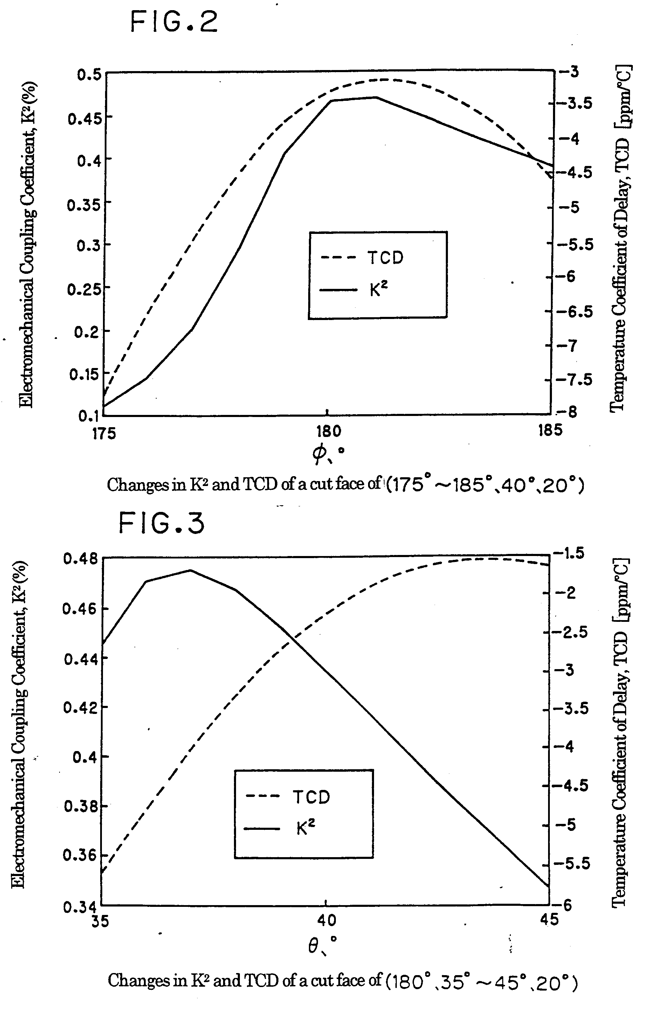

Here, it is found that as ranges of angles whereby the absolute value of TCD having 5 ppm or less and the electromechanical coupling coefficient K² having 0.3 % or more are obtained, α=-2° through +6°, β=-4° through +9°, γ=-1° through +9° or orientations equivalent thereto are preferable when Eulerian angles expression are designated by (180°+α, 40°+β, 20°+γ), by simultaneously solving Newton's equation of motion, equation of piezoelectricity and quasi- electrostatically approximated Maxwell's equation at the surface of the piezoelectric substrate by using the constants shown by Table 1 and Table 2 (refer to Fig. 2 through Fig. 4).$\text{TCD= γ - (1/V) (∂V/∂T)}$
V: Sound speed of surface acoustic wave at temperature T=25°C,
T: Temperature,
γ: Thermal expansion coefficient of cut face propagation direction under consideration.

Here, as a film thickness h of an electrode material, when a wavelength of a surface acoustic wave is designated by notation λ, a range of h/λ=0.005 through 0.2 is preferable. Further, aluminum is suitable as an electrode material, as other materials, gold may be used, aluminum + titanium may be used, or aluminum + copper is also suitable.

A pattern of the transmission type surface acoustic wave filter shown by the schematic view of Fig. 1 is formed by a photolithography step in a cut face and a propagation direction represented by (180°, 140°, 20°) in Eulerian angles expression.

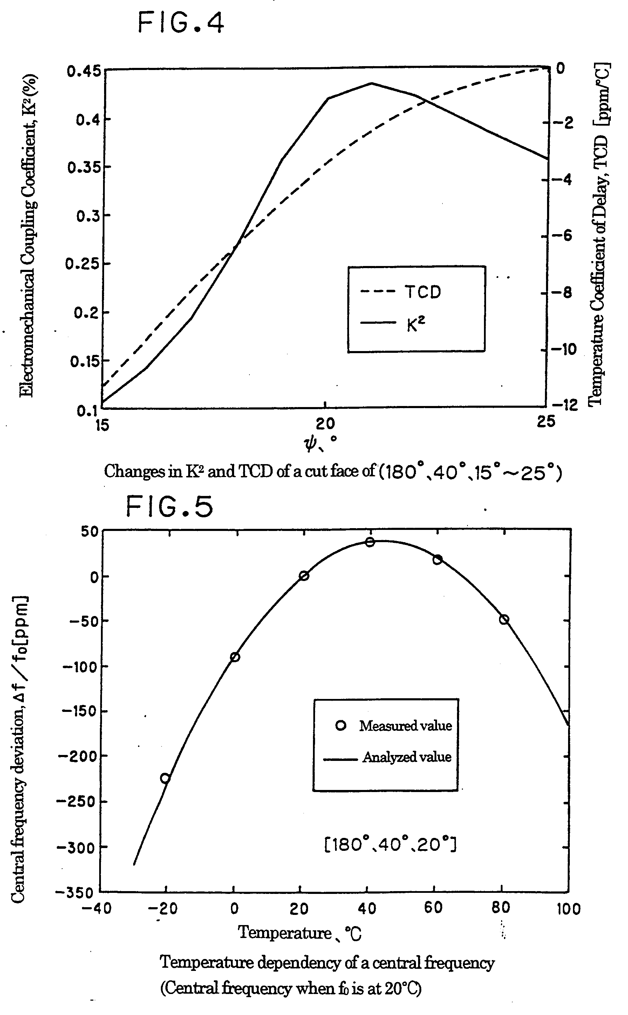

In this case, a line width and a line interval of the comb-like electrodes are respectively 4 µm, numbers of pairs of electrodes on input and output sides are respectively 30 pairs and a length of an opening of the comb-like electrode is 400 µm. Aluminum is used as the material of the electrode and the film thickness is constituted to 2400 Angstrom (h/λ=1.5 %) by a sputtering process. The element is mounted onto a metal package and the comb-like electrodes for transmission and reception are led out by a wire bonding and connected to a network analyzer. Further, when the device is put into a thermostat and a change of a central frequency is measured in a temperature range of -20°C through 80°C, a characteristic shown by Fig. 5 is obtained and it is confirmed that TCD(=-TCF)=3 ppm/°C at 25°C.

Next, an explanation will be given of a second embodiment of the present invention.

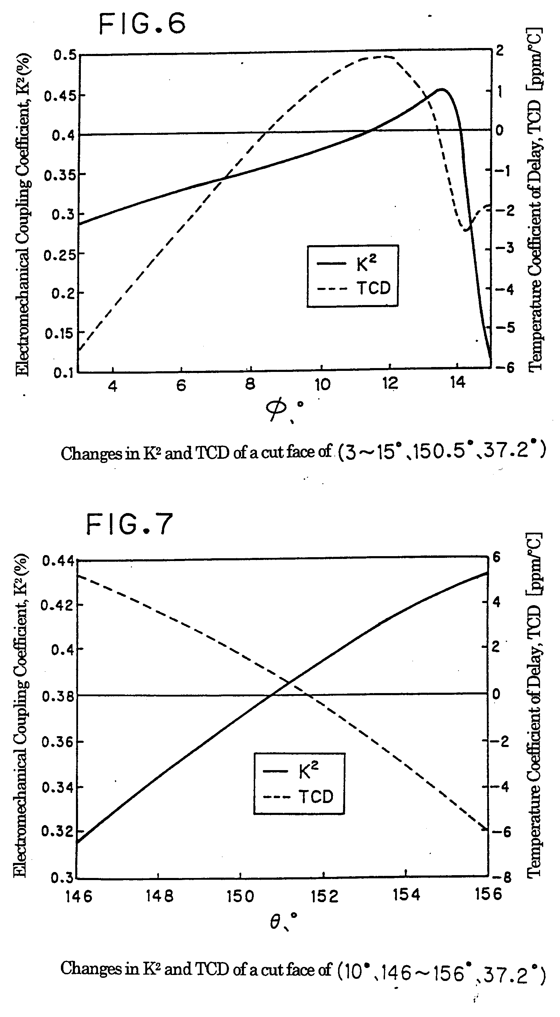

Here, it is found that as ranges of angles whereby the absolute value of TCD having 7 ppm or less and the electromechanical coupling coefficient K² having 0.1 % or more are obtained, α=-6° through 6°, β=-5° through 5°, γ=-5° through 5° or orientations equivalent thereto are preferable when Euleraian angles expression are designated by (9°+α, 150°+β, 37°+λ), by simultaneously solving Newton's equation of motion, equation of piezoelectricity and quasi- electrostatically approximated Maxwell's equation at the surface of the piezoelectric substrate by using the constants shown in Table 1 and Table 2. As a result of a further detailed investigation, it is found that in the case of (13.4°, 150.5°, 37.2°) in Eulerian angles expression or orientations equivalent thereto, TCD=0 ppm/°C and K²=0.45 % and the orientations are preferable (refer to Fig. 6 through Fig. 8).

Here, TCD is represented by Equation (1), mentioned above. Also, similar to the above-described first embodiment, in respect of the film thickness h of electrode material, when the wavelength of the surface acoustic wave is designated by notation λ, a range of h/λ=0.005 through 0.2 is preferable. Further, aluminum is suitable as electrode material, as other material, gold may be used, aluminum + titanium may be used or aluminum + copper is also suitable.

A pattern of the transmission type surface acoustic wave filter shown by the schematic view of Fig. 1 is formed by a photolithography step in a cut face and a propagation direction represented by (13.4°, 150.5°, 37.2°) in Eulerian angles expression.

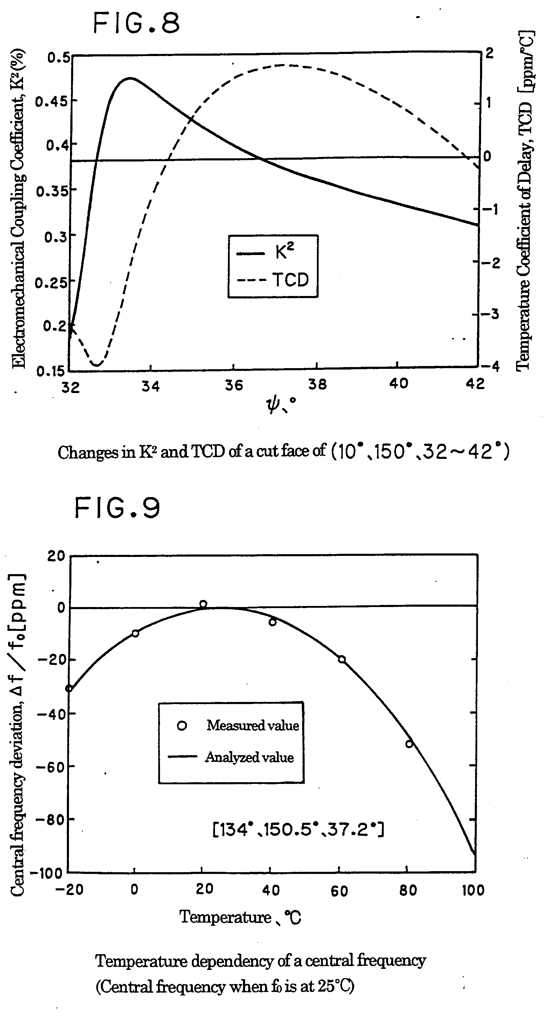

In this case, a line width and a line interval of the comb-like electrodes are respectively 4 µm, numbers of pairs of the electrodes on input and output sides are respectively 30 pairs and a length of an opening of the comb-like electrode is 400 µm. Aluminum is used as the material of the electrode and the film thickness is constituted to 2400 Angstrom (h/λ=1.5 %) by a sputtering process. The element is mounted onto a metal package and the comb-like electrodes for transmission and reception are led out by a wire bonding and connected to a network analyzer. Further, when the device is put into a thermostat and the change of a central frequency is measured in a temperature range of -20°C through 80°C, a characteristic shown by Fig. 9 is obtained and it is confirmed that TCD(=-TCF) is substantially 0 ppm/°C at 25°C.

Next, an explanation will be given of a third embodiment of the present invention.

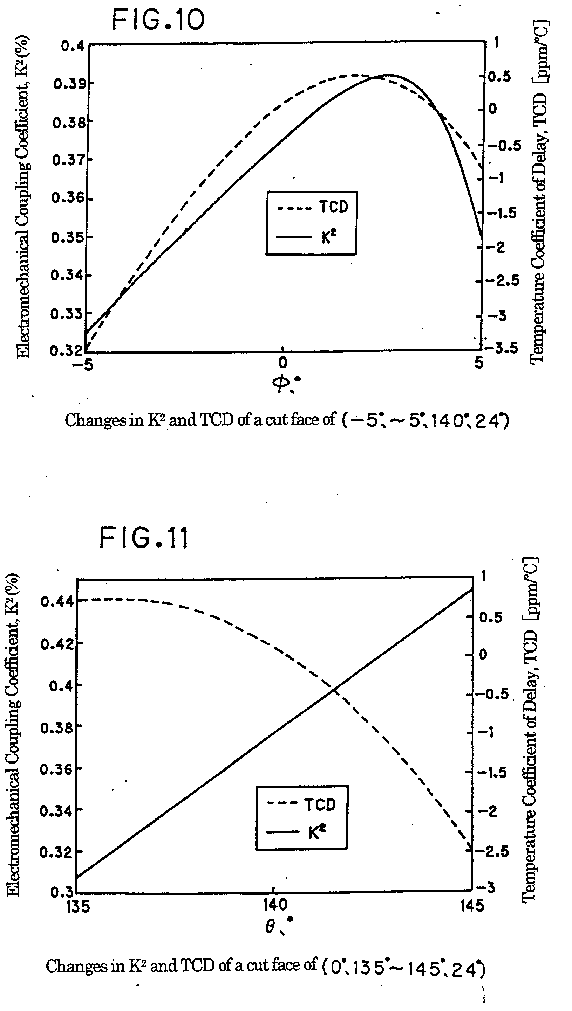

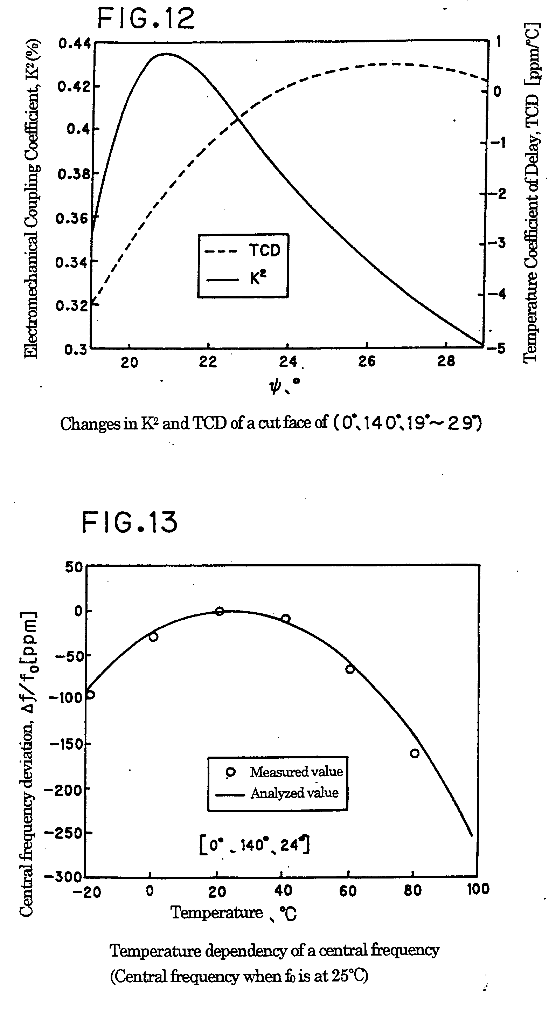

Here, by solving simultaneously Newton's equation of motion, equation of piezoelectricity and quasi-electrostatically approximated Maxwell's equation at the surface of piezoelectric substrate by using the constants shown by Table 1 and Table 2, it is found that the absolute value of TCD at temperature of 25°C is 5 ppm/°C or less and the electromechanical coupling coefficient K² is 0.3 % or more in a range of (-5° through 5°, 140°, 24°) (refer to Fig. 10), a range of (0°, 135° through 145°, 24°) (refer to Fig. 11), and a range of (0°, 140°, 19° through 29°) (refer to Fig. 12) or ranges of orientations equivalent to these ranges in Eulerian angles expression. As a result of further detailed investigation, it is found that TCD=0 ppm/°C and K²=0.375 % are obtained in the case of(0°, 140°, 24°) in Eulerian angles expression or orientations equivalent thereto, which are preferable orientations for a SAW (surface acoustic wave) device. In this case, TCD is expressed by Equation (1), mentioned above.

Further, similar to the above-described cases of the first embodiment and the second embodiment, in respect of the film thickness h of the material of the electrode, when the wavelength of the surface acoustic wave is designated by notation λ, a range of h/λ=0.005 through 0.2 is preferable. Further, aluminum is suitable as the material of the electrode, as other material, gold may be used, aluminum+titanium may be used, or aluminum+copper is suitable. Further, metals of molybdenum, tungsten and the like are widely suitable.

A pattern of the transmission type surface acoustic wave filter shown by the schematic view of Fig. 1 is formed by a photolithography step in a cut face and a propagation direction represented by (0°, 140°, 24°) in Eulerian angles expression.

In this case, a line width and a line interval of the comb-like electrodes are respectively 4 µm, numbers of couples of electrodes on input and output sides are respectively 30 pairs and a length of an opening of the comb-like electrode is 400 µm. Aluminum is used as the material of the electrode and the film thickness is constituted to 2400 Angstrom (h/λ=1.5 %) by a sputtering process. The element is mounted onto a metal package and the comb-like electrodes for transmission and reception are led out by a wire bonding and connected to a network analyzer. Further, when the device is put into a thermostat and a change of a central frequency is measured in a temperature range of -20°C through 80°C, a characteristic shown by Fig. 13 is obtained and it is confirmed that TCD(=-TCF) at 25°C is substantially 0 ppm/°C.

## Claims

1. A surface acoustic wave element in which a metal film for exciting, receiving or reflecting a surface acoustic wave is formed on a substrate of langasite (La₃Ga₅SiO₁₄) single crystal, wherein when a cut-out angle from the single crystal of the langasite substrate and a direction of propagating the surface acoustic wave are designated by (180°+α, 40°+β, 20°+γ) in Eulerian angles expression, α=-2° through +6°, β=-4° through +9°, γ=-1° through +9° or an orientation equivalent thereto.

2. A surface acoustic wave element in which a metal film for exciting, receiving or reflecting a surface acoustic wave is formed on a substrate of langasite (La₃Ga₅SiO₁₄) single crystal, wherein when a cut-out angle from the single crystal of the langasite substrate and a direction of propagating the surface acoustic wave are designated by (9°+α, 150°+β, 37°+γ) in Eulerian angles expression, α=-6° through 6°, β=-5° through 5°, γ=-5° through 5° or an orientation equivalent thereto.

3. The surface acoustic wave element according to Claim 2, wherein the cut-out angle from the single crystal of the langasite substrate and the direction of propagating the surface acoustic wave are (13.4°, 150.5°, 37.2°) in Eulerian angles expression or an orientation equivalent thereto.

4. A surface acoustic wave element in which a metal film for exciting, receiving or reflecting a surface acoustic wave is formed on a substrate of langasite (La₃Ga₅SiO₁₄) single crystal, wherein when a cut-out angle from the single crystal of the langasite substrate and a direction of propagating the surface acoustic wave are designated by (0°+α, 140°+β, 24°+γ) in Eulerian angles expression, α=-5° through 5°, β=-5° through 5°, γ=-5° through 5° or an orientation equivalent thereto.

5. The surface acoustic wave element according to Claim 4, wherein the cut-out angle from the single crystal of the langasite substrate and the direction of propagating the surface acoustic wave are (0°, 140°, 24°) in Eulerian angles expression or an orientation equivalent thereto.
